# EUROPEAN PATENT APPLICATION

(11) **EP 4 387 110 A1**
(43) Date of publication of application: **19.06.2024**
(21) Application number: 22213012.2
(22) Date of filing: 13.12.2022
(51) Int. Cl.: H04B 1/48, H03H 7/46, G01R 33/36, H03F 3/20

(54) **ELECTRIC CIRCUIT FRAGMENT WITH TRANSMIT/RECEIVE SWITCH TOPOLOGY**

(71) Applicant: Koninklijke Philips N.V., 5656 AG Eindhoven (NL)
(72) Inventor: GLEICH, Bernhard, Eindhoven (NL); SCHMALE, Ingo, Eindhoven (NL); RAHMER, Juergen Erwin, 5656AG Eindhoven (NL)
(74) Representative: Philips Intellectual Property & Standards

(57) **Abstract**

The invention relates to an electric circuit fragment comprising a coil, a low noise amplifier, a first switch, a power amplifier and a second switch. The coil is configured for generating an oscillating magnetic field in a transmit state and/or for detecting an external oscillating magnetic field in a receive state. The low noise amplifier is connected in series to the coil. The first switch is connected in parallel to the low noise amplifier and is configured to short-circuit input-terminals of the low noise amplifier. The power amplifier is connected in series to the low noise amplifier. The second switch is arranged between the power amplifier output and ground potential, and is configured to ground the power amplifier output in the receive state. Thereby, it is possible to improve the shielding of the low noise amplifier, in particular, during the transmit state of the electric circuit fragment.

## Description

### FIELD OF THE INVENTION

The present invention relates to an electric circuit fragment with transmit/receive switch topology for or of an electric circuit, a method of bringing an electric circuit fragment in its transmit state or in its receive state and to a computer program for controlling an electric circuit fragment with transmit/receive switch topology. The present invention may be used in conjunction with a micro-magnetic resonator (MMR) that sometime also is referred to as a magneto-mechanical oscillator (MMO). The MMR may be employed, e.g., for wireless remote tracking and sensing, e.g., in entertainment, sports, or medical applications. For example, the MMR may be used for body tracking and sensing.

### BACKGROUND OF THE INVENTION

Various systems are known for implementing wireless remote tracking and sensing functionality, e.g., for body tracking and sensing. Known wireless remote tracking and sensing systems include *inter alia* optical systems having one or more cameras that capture the position of passive or active markers, as well as electromagnetic tracking systems based on LC-resonators. Furthermore, inertial motion capture technology based on inertial measurements units (IMU) containing a combination of gyroscope, magnetometer, and accelerometer, to measure rotational rates can be employed. Moreover, mechanical, magnetic or magneto-mechanical systems are known for wireless remote tracking and sensing.

Magneto-mechanical systems often include an MMR for implementing the wireless remote tracking and sensing functionality. The wireless remote tracking and sensing functionality generally includes a magnetic excitation of a mechanical resonance of a ferromagnetic object. To this end, an MMR detector system may include electronics comprising one or more coils and amplifiers. For example, a transmitter coil may be used for generating an oscillating magnetic field for excitation of a mechanical resonance of a ferromagnetic object. The mechanical resonance of the ferromagnetic object generates an oscillating magnetic field that can be detected as an external oscillating magnetic field by a sensor coil.

Yet, it is still desirable to provide MMRs enabling a more sensitive and reliable tracking and sensing functionality.

### SUMMARY OF THE INVENTION

The present invention is based on the objective of providing an electric circuit fragment for or of an electric circuit that provides an improved transmit/receive switch topology. The present invention is based on the further objective of providing an improved method of bringing an electric circuit fragment in its transmit state or in its receive state. Moreover, the present invention is based on the objective of providing a computer program for controlling an electric circuit fragment with an improved transmit/receive switch topology.

According to the invention, an electric circuit fragment for or of an electric circuit is proposed. The electric circuit fragment has a transmit state and a receive state. The electric circuit fragment comprises at least one coil, a low noise amplifier, a first switch, a power amplifier, and a second switch. The at least one coil is configured for generating an oscillating magnetic field in the transmit state and/or for detecting an external oscillating magnetic field in the receive state. The low noise amplifier is connected in series to the at least one coil and is configured for amplifying a first voltage signal induced in the at least one coil by the detected external oscillating magnetic field in the receive state. The first switch is connected in parallel to the low noise amplifier and is configured to shorten the low noise amplifier in the transmit state by switching the first switch into its conductive state or to switch into its isolating state in the receive state. The power amplifier is connected with its power amplifier output in series to the low noise amplifier and is configured for amplifying a received second voltage signal and for providing an amplified second voltage signal to the at least one coil in the transmit state, preferably, for generating the oscillating magnetic field in the transmit state. The second switch is arranged to connect the power amplifier output to a ground potential, and is configured to ground the power amplifier output in the receive state by switching to its conductive state and to switch in the transmit state to its isolating state.

The invention includes the recognition that it is beneficial to use a single coil for both, generating an oscillating magnetic field and detecting an external oscillating magnetic field, e.g., to save space. During a transmit (Tx) phase, the power amplifier (PA) generally applies a comparatively high voltage, e.g. 48V, to the coil. During a receive (Rx) phase, a comparatively weak signal, e.g. few mV, is typically detected by the coil and is amplified by the low noise amplifier (LNA). In order to not to destroy, overdrive, or saturate the sensitive LNA, the LNA typically needs to be shielded from the high voltages during the Tx phase. However, known topologies for switching between the PA and LNA do not provide adequate insulation, particularly during the Rx phase. In fact, in many known configurations, the insulation between LNA and PA is insufficient, such that especially noise from the PA is an issue during the Rx phase. With the electric circuit fragment, it is possible to overcome the insufficient insulation of such known topologies for switching between Tx and Rx states of a coil, e.g., in a micro-magnetic resonator remote sensing and tracking system, by using the first switch in parallel with a LNA.

This is possible with the electric circuit fragment due to its specific topology that has the PA and LNA not in parallel but in series. In fact, it was found that with current semiconductor devices, it is typically best to have a series connection of the PA and LNA and to alternately short one of the PA and LNA. To this end, the first switch can short the LNA and the second switch can ground the PA output.

This has the advantage that during Rx phase, the first switch can be isolating, and the second switch can be conductive. Thereby, the parasitic capacitance of the first switch when isolating does not deteriorate the Rx signal quality and the second switch can efficiently shorten any potential interference from the PA towards ground. This allows to neither destroy, overdrive nor saturate the sensitive LNA by shielding the LNA from the high voltages during Tx phase. This can be achieved by the specific topology of the electric circuit fragment.

In particular, in operation of the electric circuit fragment, in the Rx state, the first switch can be isolating, and the second switch can be conductive. The first voltage signal then passes the LNA and the second switch without entering the PA at its power amplifier output. The first voltage signal travels from the coil towards the LNA. In the Rx state, the power amplifier output can be grounded by switching the second switch in its conductive state. If the power amplifier output is grounded, interference with noise produced by the PA can be prevented. The function of the second switch is thus to shorten any potential interference from the PA towards ground during Rx phase, whilst during Tx phase, it does not have any negative side effect. Accordingly, during Rx phase, it is beneficial that the PA does not produce noise in the coil and during the Tx phase, the LNA advantageously can be protected from the high voltage of the PA.

Moreover, in operation of the electric circuit fragment, in the Tx state, the first switch can be conductive and the second switch can be isolating. The received second voltage signal can be amplified by the PA and pass the first switch without traversing the LNA, i.e., the input terminals of the LNA are shortened. The amplified second voltage signal travels from the PA towards the coil. Advantageously, with the electric circuit fragment, the LNA can be shielded from the high voltages during Tx phase such that a risk of destroying, overdriving or saturating the LNA can be significantly reduced.

Preferably, the power amplifier is configured for amplifying the received second voltage signal and for providing an amplified second voltage signal of 10 V or more, preferably, of 40 V or more, e.g. in the order of 48 V. The first voltage signal received by the LNA may be 1 V or less, .e.g., in the order of a few mV. The external oscillating magnetic field can be generated by a ferromagnetic object of a micro-magnetic resonator and can be detected by the electric circuit fragment in its receive state. The term "external" thus refers to external from the electric circuit fragment.

Preferably, the electric circuit fragment is part of an electric circuit that may be composed of a plurality of individual electronic components, such as resistors, transistors, capacitors, inductors and diodes, connected, e.g., by conductive wires or traces through which electric current can flow. An amplifying transistor in the LNA can be a junction-gate field-effect transistor (jFET). The PA can have an H-bridge output stage. The H-bridge, preferably, is an internal part of the PA and can be put in short mode. In particular, if the PA includes a preferentially digitally switchable H-bridge, no additional switch may be needed for the PA as the H-bridge can be put in a low impedance state by switching, e.g., one or both H-bridge's low side transistor to conductive state. Accordingly, it is possible that the electric circuit fragment is configured such that the power amplifier output is configured as an H-bridge that is configured such as to short-circuit output terminals of the power amplifier output when in receive state.

It is preferred that the first switch and/or the second switch is of a transistor-based switch type. For example, the first switch and/or the second switch may be a field-effect transistor, e.g., a metal-oxide-semiconductor field-effect transistor (MOSFET). Optionally, at least one of the first switch and/or the second switch may be a positive intrinsic negative (PIN) diode. Yet, a MOSFET is preferred over a PIN diode due to its generally lower costs. When using a MOSFET, it is further preferred that in a switching operation the low impedance of MOSFET is used for the conduction. This can be better than the high impedance state as the MOSFET may have considerable residual capacitance when in insulating state. This may avoid the use of generally costly PIN diodes as switches. However, still PIN diodes may be used as switches in addition or as an alternative to a MOSFET.

As mentioned above, it is preferred that the electric circuit fragment includes a single coil for generating an oscillating magnetic field in the transmit state and for detecting an external oscillating magnetic field in the receive state. However, it is also possible that the electric circuit fragment comprises a first coil for generating the oscillating magnetic field in the transmit state and a separate second coil for detecting the external oscillating magnetic field in the receive state. These two coils may strongly be inductively coupled, weakly coupled or not coupled at all.

Optionally, the electric circuit fragment may comprise a transformer connected in parallel to the low noise amplifier and in parallel to the first switch for transforming the first voltage signal provided by the at least one coil before it enters the low noise amplifier. A transformer, e.g., a cored transformer, can be employed for amplifying the first voltage signal before it enters the LNA. Moreover, using a transformer can be beneficial for impedance matching.

With a transformer, the insulation of the ground potential can be achieved (DC-decoupling). Due to the high currents, a direct connection of the LNA is often inferior as the potential of the two input ports will vary, i.e., a common mode signal, due to resistance and inductance of the leads in the circuit. With the transformer, it is possible to improve a common mode rejection ratio.

In addition, the transformer can be used to transform the impedance of the coil to be more suitable for the LNA. Usually, it is preferable to provide the at least one coil, i.e., the send and/or receive coil, with relatively low impedance for a good performance of the PA. However, the LNA usually, at least when operating at very low noise, operates best at a much higher coil impedance. The transformer may solve this problem. The transformer makes it possible to operate a single ended LNA in the circuit, which means that one of the input terminals of the LNA is grounded. Technically, this may be similar to improving the common mode rejection ratio. The transformer may also be used to feed in some additional signals, like a Pilot tone, i.e. an additional very low power signal.

Preferably, the electric circuit fragment with a transformer comprises a third switch that is connected in series between the low noise amplifier and the transformer. In operation of the electric circuit fragment, the third switch, preferably, is isolating in the Tx state and conductive in the Rx state. Having a third switch that is connected in series between the low noise amplifier and the transformer may yield the advantage that the rejection of unwanted signals can further be improved. In particular, the additional third switch may improve the immunity of the LNA during the Tx phase. Moreover, when having a third switch connected in series between the LNA and the transformer, the amplified second voltage signal may interfere less with the LNA and therefore the acquisition may speed up.

In some implementations on the LNA, it is preferred that the LNA is not only protected from damage, for which the first switch is usually sufficient, but the residual send signal on the input of the LNA shall be so low that the LNA does not go into an undesired overdrive mode. Recuperating from overdrive mode generally may take time, and therefore the time between send and receive may be longer than necessary.

It is possible that only the first and the second switch are employed. Optionally, further switches such as the third switch can be employed for implementing further functionalities or for realizing further advantages of electric circuit fragment. That is, because a switch when open in general still has a residual capacitance. This allows some signal to be still transmitted over the open switch, which is generally not wanted. Therefore, additional means, i.e., switches, to reduce the capacitance of the transistor output may be employed. Typically, MOSFET switches consist of two series MOSFET transistors with opposite direction. To reduce the capacitance, a voltage to the common pin of the two transistors relative to the terminal pins can be applied. This additional voltage may reduce the capacitance.

For example, additionally or alternatively to the third switch, the electric circuit fragment may comprise a fourth switch that is connected in parallel to the LNA and in parallel to the transformer. In operation of the electric circuit fragment, the fourth switch, preferably, is isolating in the Rx state and conductive in the Tx state. That is, if the third switch and the fourth switch are present, preferably, in operation, the third switch is conductive and the fourth switch is isolating in the Rx state and the third switch is isolating and the fourth switch is conductive in the Tx state.

When employing pairs of additional switches, e.g., the third switch and the fourth switch, these switches may work as voltage dividers. In the Tx state, the third switch may be high-impedance, and fourth switch may be low impedance. As a result, undesired residual Tx signal arriving at the secondary winding of the transformer would see this voltage divider, and only a smallest fraction of that voltage would then appear across the shorted fourth switch, which is the same voltage as across the input of the LNA.

If the fourth switch is not present but only the third switch, the voltage division may work less efficient, as then the high impedance of the third switch would be in series with the also high impedance of the LNA input. The voltage division in that case may only be weakly reducing the voltage on the LNA input. Still, in certain applications, employing only the third switch and not the fourth switch may be sufficient.

If the third switch is not present but only the fourth switch, the voltage division may also work less efficient, as in that case, the fourth switch is basically parallel to the first switch, e.g., on the primary side of the transformer, where it may only marginally help. So whilst just using one switch, either the third switch or the fourth switch, is feasible, it is preferred to use the third and the fourth switches in pairs in in the electric circuit fragment.

Adding more switches could be of advantage to improve the voltage division effect. Then the voltage division ladder may be continued in the same way, i.e., a fifth switch would be again in series, and sixth switch would be in parallel and so on.

Preferably, the transformer is a symmetrical transformer. For example, it is possible that in the electric circuit fragment, an electrically single-ended configuration is translated into a balanced configuration, with a symmetrical power amplifier, symmetrical switches, a symmetrical coil, and a transformer having two symmetrical primary sides. A symmetrical PA, in general, has both positive and negative power supply rails and a signal rises and falls centered on the 0 volts point exactly in between.

With the symmetrical transformer, it is possible to suppress common mode disturbances entering the LNA via the at least one coil. In particular, it is the purpose of the symmetric primary side of the transformer to suppress a common mode signal that could be captured by the coil.

The present invention also relates to a detector system for a micro-magnetic resonator that can be used for tracking and/or sensing, preferably, for wireless remote tracking and/or sensing. The detector system comprises one or more ferromagnetic objects that can mechanically oscillate (upon excitation of the ferromagnetic object's mechanical resonance). The detector system has the capability to excite this mechanical oscillation of the ferromagnetic object by applying an oscillating magnetic field. Furthermore, this detector system has the capability of detecting and examining a received external oscillating magnetic field, which comes from the mechanical oscillation of the ferromagnetic object.

The detector system comprises an electric circuit that includes the above-described electric circuit fragment, to enable these two capabilities

The electric circuit fragment is arranged and configured for generating an oscillating magnetic field in the transmit state for excitation of a mechanical resonance of the ferromagnetic object such that the ferromagnetic object in turn generates an external oscillating magnetic field that can be detected by the electric circuit fragment in its receive state. Preferably, the ferromagnetic object is or includes a permanent magnet. A mechanical resonance may be excited by means of an oscillating magnetic field transmitted by the electric circuit fragment's coil in the Tx state. The oscillating permanent magnet in the detector system may generate an external oscillating magnetic field that is picked up by a coil and amplified by the LNA. In body tracking or sensing, in the detector system, an oscillation, i.e., a mechanical resonance, is excited by the coil in the Tx state. The oscillation induces a voltage, i.e., the first voltage signal, in a coil that senses the oscillation in the Rx state. The detector system has the advantage that due to the specific topology of the electric circuit fragment, in the Rx state, the PA does not produce noise in the LNA and during the Tx state, the LNA is protected from the high power of the PA. Thereby, the detector system can work comparatively accurate and reliable.

In operation of the detector system, e.g. in combination with a micro-magnetic resonator, oscillating magnetic fields can be generated by the (plurality of) coil(s), that are powered/driven by the (at least) one PA of the electric circuit fragment. Tracking of the micro-magnetic resonator may be achieved based on a comparison of amplitudes of detected external oscillating magnetic fields. Therefore, if spatial information are required, a plurality coils, e.g., at least there coils, should be employed. Sensing may be achieved with the micro-magnetic resonator based on a detection of the self-decay frequency of the detected external oscillating magnetic field. The self-decay frequency is a property of the micro-magnetic resonator, and can differ from the excitation frequency in the Tx phase. For sensing, one coil, one LNA and one PA is sufficient.

The present invention further relates to a method of operating the electric circuit fragment described above. Operating the electric circuit fragment may comprise bringing the electric circuit fragment in its transmit state or in its receive state. The method comprises the steps of:
- switching the first switch into its conductive state to shorten the low noise amplifier and switching the second switch into its isolating state, for bringing the electric circuit fragment into its transmit state, and
- switching the first switch into its isolating state and switching the second switch into its conductive state to shorten/ground the power amplifier output. In the method, preferably, the Tx state and the Rx state are time-multiplexed, for bringing the electric circuit fragment into its receive state.

The method may further comprise switching the first switch from its conductive state in its isolating state or *vice versa* after a first predefined time period that begins with a switching of the second switch from its conductive state in its isolating state or *vice versa.* Additionally or alternatively, the method may further comprise switching the second switch from its conductive state in its isolating state or *vice versa* after a second predefined time period that begins with a switching of the first switch from its conductive state in its isolating state or *vice versa.* Thereby, it is possible to take into account the circumstance that the actual switching time of a transistor may be different from the time at which a transistor is controlled to switch. That is, there may be a time delay, and this delay, specific for a transistor, can be different for turning on and turning off. With the method, it is possible to shorten the first and/or second switch e.g. at the PA but some additional time is added until the LNA switch, e.g., the first switch, is opened, especially, if there is residual current flowing through the coil.

Additionally or alternatively, the method may further comprise switching the first switch into its conductive state while the second switch is still in its conductive state or comprising switching the second switch into its conductive state while the first switch is still in its conductive state. This is, because it may also be beneficial to have a short time both switches, i.e. the first and second switches, open to quickly bring any residual current in the coil to zero.

Optionally, in the method, the first switch may be opened relatively slowly, e.g., slower than the second switch. Thereby, LNA overloading can be avoided.

The present invention also relates to a computer program for controlling the electric circuit fragment described above. The computer program comprises program code such as, e.g., executable instructions, for causing the electric circuit fragment to switch from its transmit state into its receive state or *vice versa* by implementing the above-described method, when run on a computing device such as a personal computer (PC), a field programmable gate array (FPGA), microcontroller or a complex programmable logic device (CPLD), a processor, a processing circuit, or other computing device. The present invention also relates to a non-transitory computer readable data medium storing the computer program.In summary, the present invention relates to an electric circuit fragment for or of an electric circuit, the electric circuit fragment having a transmit state and a receive state. The electric circuit fragment comprises at least one coil, a low noise amplifier, a first switch, a power amplifier and a second switch. The at least one coil is configured for generating an oscillating magnetic field in the transmit state and/or for detecting an external oscillating magnetic field in the receive state. The low noise amplifier is connected in series to the at least one coil and is configured for amplifying a first voltage signal induced in the at least one coil. The first switch is connected in parallel to the low noise amplifier and is configured to shorten the inputs of the low noise amplifier in the transmit state. The power amplifier is connected with its power amplifier output in series to the low noise amplifier and is configured for amplifying a received second voltage signal and for providing an amplified second voltage signal to the at least one coil in the transmit state for generating the oscillating magnetic field. The second switch is arranged to connect the power amplifier output to a ground potential, and is configured to ground the power amplifier output in the receive state by switching to its conductive state. Thereby, it is possible to improve the shielding of the low noise amplifier, in particular, during the transmit state of the electric circuit fragment.

It shall be understood that the electric circuit fragment of claim 1, the detector system of claim 10, the method of claim 11, and the computer program of claim 14, have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter. In particular, the present invention includes the following technical advantages: With the specific topology of the electric circuit fragment, shielding of the low noise amplifier can be achieved. This is achieved by an efficient decoupling between Tx state and Rx state of the electric circuit fragment. In particular, the electric circuit fragment provides an improved isolation of LNA with respect to noise in the Rx state. This leads to improved noise interference properties and improved Rx signal quality properties of the electric circuit fragment. Technically, this advantage is achieved by the specific topology of the electric circuit fragment enabling that during the Rx phase, the capacitance of the first switch does not deteriorate the Rx signal quality and the second switch very efficiently shortens any potential interference from the PA towards the ground. As a consequence, a risk of destroying, overdriving or saturating the LNA can be significantly reduced. The electric circuit fragment as part of a detector system can therefore be used to implement a sensitive and reliable tracking and sensing functionality, e.g., as part of micro-magnetic resonators employed, e.g., in-body tracking and sensing.

### BRIEF DESCRIPTION OF THE DRAWINGS

In the following drawings:
Fig. 1 schematically and exemplary shows an electric circuit fragment with a topology known from the prior art,
Fig. 2 schematically and exemplary shows a detector system for a micro-magnetic resonator, the detector system comprising a ferromagnetic object and an electric circuit with an electric circuit fragment according to the present invention,
Fig. 3 schematically and exemplary shows an electric circuit fragment according to the present invention that may be used in a detector system for micro-magnetic resonators,
Fig. 4 schematically and exemplary shows an electric circuit fragment according to the present invention that may be used in a detector system for micro-magnetic resonators and that additionally includes a transformer,
Fig. 5 schematically and exemplary shows an electric circuit fragment according to the present invention that may be used in a detector system for micro-magnetic resonators and that includes a transformer and additionally a third switch and a fourth switch,
Fig. 6 schematically and exemplary shows another electric circuit fragment according to the present invention that may be used in a detector system for micro-magnetic resonators,
Fig. 7 schematically and exemplary shows that the first primary side, the second primary side and the secondary side of the transformer of the electric circuit fragment of Fig. 6 are all inductively coupled,
Fig. 8 schematically and exemplary shows another electric circuit fragment according to the present invention that may be used in a detection system for micro-magnetic resonators,
Fig. 9 schematically and exemplary shows another electric circuit fragment according to the present invention that may be used in a detection system for micro-magnetic resonators
Fig. 10 schematically and exemplary shows the second sub-unit of the electric circuit fragment of Fig. 6 with a sketched differential mode signal that adds up constructively, and
Fig. 11 schematically and exemplary shows the second sub-unit of the electric circuit fragment of Fig. 6 with a sketched common mode signal that is suppressed.

### DETAILED DESCRIPTION OF EMBODIMENTS

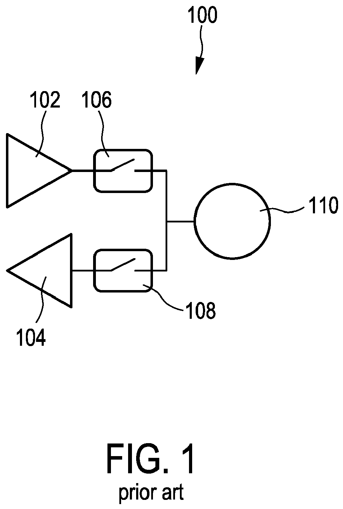

Fig. 1 schematically and exemplary shows an electric circuit fragment 100 with a topology known from the prior art, e.g., from WO 2015/043612 A1. The electric circuit fragment 100 includes a power amplifier 102 that is connected in parallel to a low noise amplifier 104. The power amplifier 102 is connected in series to a first switch 106 and the low noise amplifier 104 is connected in series to a second switch 108. In operation, the first switch 106 can be conductive and the second switch 108 can be isolating or *vice versa.* Accordingly, in the transmit state of the electric circuit fragment 100, the first switch 106 is conductive and the second switch 108 is isolating, such that an amplified voltage signal can be provided from the power amplifier 102 to a coil 110 for generating an oscillating magnetic field. Moreover, in the receive state of the electric circuit fragment 100, the second switch 108 is conductive and the first switch 106 is isolating such that a voltage signal induced in the coil 110 by an external oscillating magnetic field can be provided to and amplified by the low noise amplifier 100. There are several requirements on the switches 106, 108 such as low loss when conductive, low capacitance when isolating and fast transition time between the two modes, i.e., the transmit state and the receive state.

However, it was found that with this known topology, while it is good enough to protect the low noise amplifier 104, it does not provide sufficient isolation with respect to noise. This noise emanates from the power amplifier 102 and the power supply (not shown) connected to it and enters the low noise amplifier 104. This is caused by the tradeoff between transmit and receive phase requirements for the first switch 106 which when optimized for having a low resistance when being conductive in the transmit state has too large capacitance when being isolating in the receive state. This tradeoff is an intrinsic dilemma with this topology. Therefore, a micro-magnetic resonator detection system for micro-magnetic resonators including the electric circuit fragment 100 typically suffers from noise interference and hence a limited receive state signal quality.

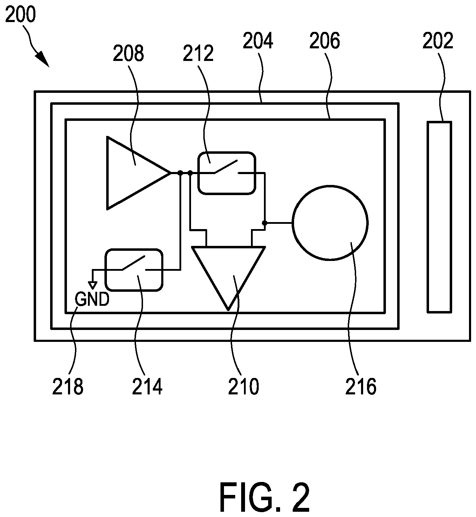

Fig. 2 schematically and exemplary shows a detector system 200 for a micro-magnetic resonator, the detector system 200 comprising a ferromagnetic object 202 that is a permanent magnet and an electric circuit 204 comprising an electric circuit fragment 206. The electric circuit fragment 206 does not suffer from the intrinsic dilemma of the topology of the electric circuit fragment 100 described with respect to Fig. 1. In the electric circuit fragment 206, the power amplifier 208 and the low noise amplifier 210 are not connected in parallel as in the electric circuit fragment 100 but in series. This has the advantage that during receive phase, the first switch 212 can be isolating and the second switch 214 can be conductive such that the capacitance of the first switch 212 does not the deteriorated the signal quality of a first voltage signal induced in the coil 216 and that is amplified by the low noise amplifier 210. Moreover, the second switch 214 efficiently shortens any potential interference from the power amplifier 208 towards the ground 218.

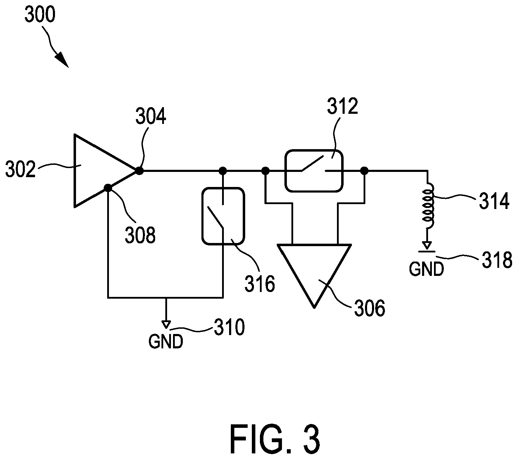

Fig. 3 schematically and exemplary shows an electric circuit fragment 300 that may be used in the detector system 200 for a micro-magnetic resonator described with reference to Fig. 2. The electric circuit fragment 300 essentially corresponds to the electric circuit fragment 200, but is shown and described with further details. The electric circuit fragment 300 includes a power amplifier 302 that is connected with its power amplifier output 304 in series to a low noise amplifier 306. The power amplifier 302 has a reference terminal 308 that is connected to ground 310. The electric circuit fragment 300 includes a first switch 312 that is connected in parallel to the low noise amplifier 306 and that can be used to short-circuit the inputs of the low noise amplifier 306 in the transmit state of the electric circuit fragment 300 by switching into its conductive state. Accordingly, in the receive state of the electric circuit fragment 300, the first switch 312 is switched into its isolating state. Thus, in the receive state, a first voltage signal induced in the coil 314 can be transmitted to and amplified by the low noise amplifier 306. The electric circuit fragment 300 includes a second switch 316 that connects the power amplifier output 304 to the ground 310 such that by switching the second switch 316 to its conductive state, the power amplifier output 304 can be grounded in the receive state of the electric circuit fragment 300. Accordingly, in the transmit state of the electric circuit fragment 300, the second switch 316 can be switched to its isolating state such that an amplified second voltage signal can be transmitted from the power amplifier 302 via the conductive first switch 312 to the coil 314. The second terminal of the coil 314 is connected to ground 318. Grounds 310 and 318 are electrically connected.

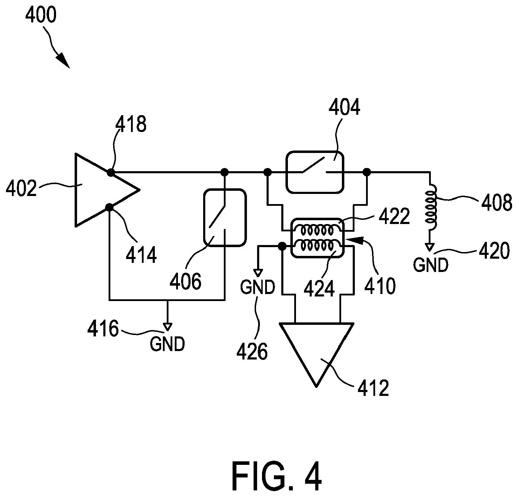

Fig. 4 schematically and exemplary shows an electric circuit fragment 400 that may be used instead of electric circuit fragment 206 and the detector system 200 for a micro-magnetic resonator described with reference to Fig. 2. The electric circuit fragment 400 includes a power amplifier 402, a first switch 404 and a second switch 406 as well as a coil 408 that are arranged and configured as described with reference to Fig. 3. The power amplifier reference terminal 414 is connected to the ground 416. The power amplifier output 418 can be grounded by switching the second switch 406 into its conductive state. With its one end, the coil 408 is connected in series with the first switch 404 and with its other end, the coil 408 is connected to the ground 420.

In addition, the electric circuit fragment 400 includes a transformer 410. The transformer 410 is connected in parallel to a low noise amplifier 412 and in parallel to the first switch 404 for transforming a first voltage signal provided by the coil 408 before it enters the low noise amplifier 412. The transformer 410 has a primary side 422 and a secondary side 424. With its primary side 422, the transformer 410 is connected in parallel to the first switch 404. With its secondary side 424, the transformer 410 is connected in parallel to the low noise amplifier 412. Moreover, with its secondary side 424, the transformer 410 is connected to the ground 426.

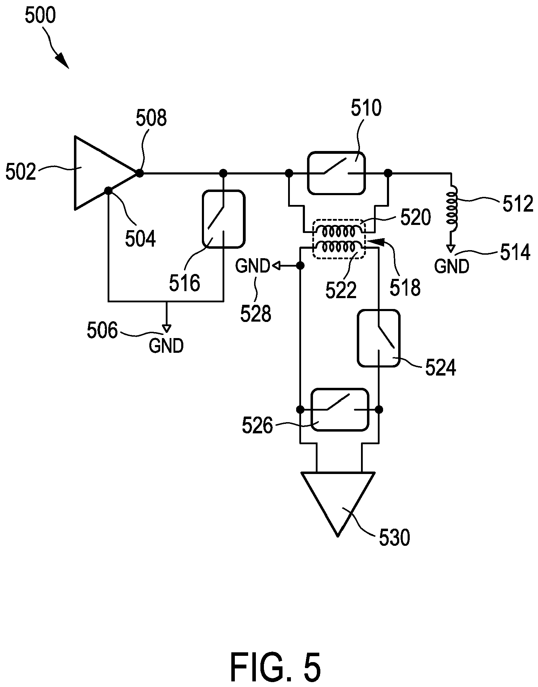

Fig. 5 schematically and exemplary shows an electric circuit fragment 500 that may be used instead of electric circuit fragment 206 in the detector system for micro-magnetic resonators 200 described with reference to Fig. 2. The electric circuit fragment comprises a power amplifier 502 that has a reference terminal 504 connected to the ground 506 and a power amplifier output 508 connected to a first switch 510 that can be switched into its conductive state in the transmit state of the electric circuit fragment 500 for transmitting an amplified second voltage signal to a coil 512 that with its one end is connected to the ground 514. In the receive state of the electric circuit fragment 500, the first switch 510 is switched into its isolating state and a second switch 516 is switched into its conductive state. The second switch 516 connects the power amplifier output 508 to the ground 506 such that in the receive state, the power amplifier 502 is grounded at its power amplifier output 508. Moreover, in the transmit state of the electric circuit fragment 500, the second switch 516 is switched to its isolating state.

As the electric circuit fragment 400 described with reference to Fig. 4, the electric circuit fragment 500, too, comprises a transformer 518 that has a primary side 520 connected in parallel to the first switch 510. A secondary side 522 of the transformer 518 is connected in series to a third switch 524 and in parallel to a fourth switch 526. Moreover, with its secondary side 522, the transformer 518 is connected to the ground 528. The third switch 524 and the fourth switch 526 work as voltage dividers wherein in the transmit state, the third switch 524 is isolating and in the receive state conductive. Accordingly, in the transmit state, the fourth switch 526 is conductive and in the receive state, the fourth switch 526 is isolating. The third switch 524 is connected in series to the low noise amplifier 530 and the fourth switch 526 is connected in parallel to the low noise amplifier 530. In particular, by using the third switch 524 and the fourth switch 526, the low noise amplifier 530 can be further protected such that an amplified second voltage signal provided by the power amplifier 502 and the transmit state of the electric circuit fragment 500 may interfere less with the low noise amplifier 530.

Including the third switch 524 and the fourth switch 526 in the electric circuit fragment 500 takes into account that switches 510 and 516 are not ideal. The remaining interference from the amplified second voltage signal towards LNA 530 can be further reduced by switches 524 and 526.

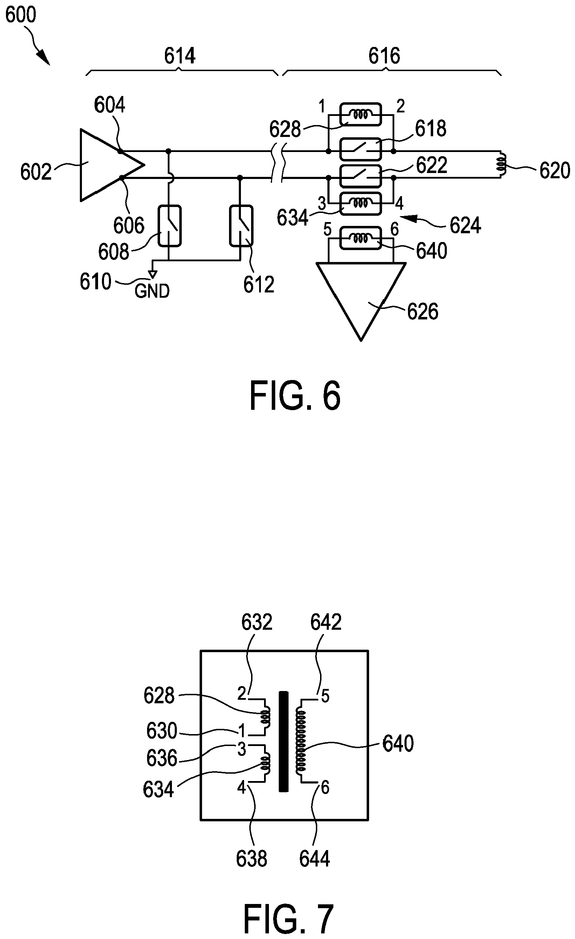

Fig. 6 schematically and exemplary shows an electric circuit fragment 600 that may be used instead of electric circuit fragment 206 in the detector system for micro-magnetic resonators 200 described with reference to Fig. 2. The electric circuit fragment 600 comprises a power amplifier 602 having a differential power amplifier output pair 604 and 606. The first power amplifier output 604 is connected to a first switch 608 that connects the first power amplifier output 604 to the ground 610. The second power amplifier output 606 is connected to a second switch 612 that connects the second power amplifier output 606 to the ground 610. The power amplifier 602, the first switch 608 and the second switch 612 constitute a first sub-unit 614 of the electric circuit fragment 600. The first sub-unit 614 is connected to a second sub-unit 616 of the electric circuit fragment 600. The second sub-unit 616 comprises a third switch 618 connected in series to the first power amplifier output 604 to a first terminal of coil 620. Furthermore, the second sub-unit 616 comprises a fourth switch 622 connected in series to the second power amplifier output 606 to a second terminal of the coil 620. The second sub-unit 616 further comprises a transformer 624 coupled in parallel to a low noise amplifier 626. The transformer 624 has two primary sides. Its first primary side 628 is coupled with a first end 630 (terminal 1) and with a second end 632 (terminal 2) in parallel to the third switch 618. Its second primary side 634 is coupled with a third end 636 (terminal 3) and with a fourth end 638 (terminal 4) in parallel to the fourth switch 622. The transformer's secondary side 640 is coupled with a fifth end 642 (terminal 5) and with a sixth end 644 (terminal 6) in parallel to the low noise amplifier 626.

As depicted in Fig. 7, the coils of the first primary side 628, the second primary side 634 and the secondary side 640 are all coupled. The purpose of the symmetric primary side 628, 634 of the transformer 624 is to suppress potential common mode signals that could be captured by the coil 620.

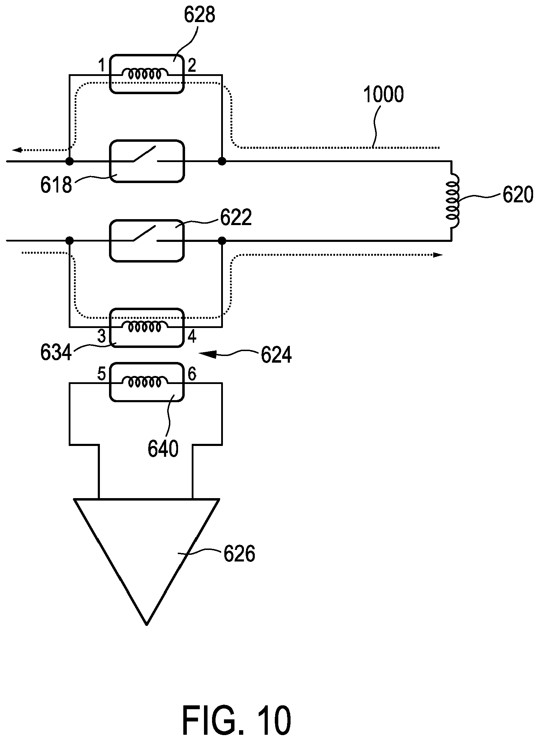

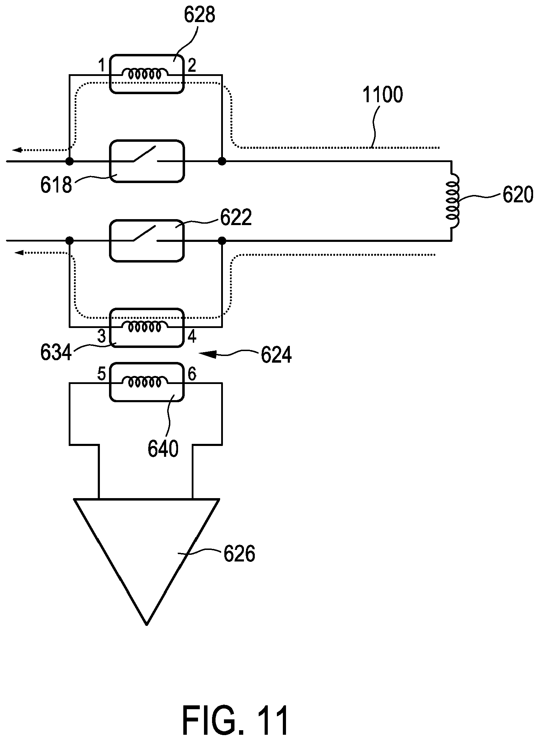

As shown in Fig. 10, the wanted differential mode signal 1000 adds up constructively, so appears between the terminal 5 and the terminal 6, the secondary side 640 of the transformer 624. As shown in Fig. 11, the common mode signal 1100, in contrast, cancels, so no voltage appears between the terminals 5 and 6.

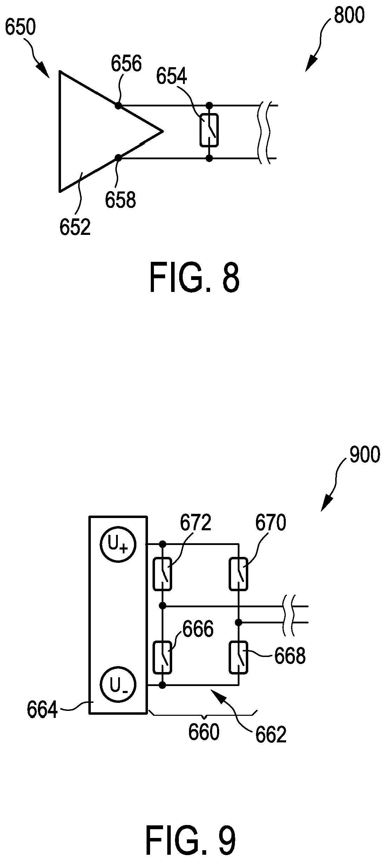

Instead of the first sub-unit 614, a third sub-unit 650 that is schematically and exemplary shown in Fig. 8 can be used and connected to the second sub-unit 616 described with reference to Fig. 6 to implement another electric circuit fragment 800 that may be used instead of electric circuit fragment 206 in the detector system for micro-magnetic resonators 200 described with reference to Fig. 2. The third sub-unit 650 comprises a power amplifier 652 and a first switch 654 that connects the two differential power amplifier outputs 656 and 658.

Fig. 9 schematically and exemplary shows a fourth sub-unit 660 that can be used and connected to the second sub-unit 616 described with reference to Fig. 6 to implement another electric circuit fragment 900. The fourth sub-unit 660 may be used as part of electric circuit fragment 206 and in particular as part of power amplifier 208 in the detector system for the micro-magnetic resonator 200 described with reference to Fig. 2. The fourth sub-unit 660 comprises a power amplifier 662 that is connected to a voltage source 664. The power amplifier 662 comprises a full H-bridge output stage including four switches 666, 668, 670, 672 that can be switched individually. Since the power amplifier 662 includes a H-bridge, no additional switches (such as switch 214 of Fig. 2 or switches 608 and 612 in Fig. 6, or switch 654 in Fig. 8) are needed in addition to the power amplifier 662 as the H-bridge can be put in a low impedance state by switching both the H-bridge's low side transistors to conductive state.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Procedures like the amplifying a first voltage signal, the amplifying a received second voltage signal, *et cetera,* performed by one or several units or devices can be performed by any other number of units or devices. These procedures, particularly the method of bringing an electric circuit fragment in its transmit state or in its receive state, can be implemented as program code means of a computer program and/or as dedicated hardware.

A computer program may be stored/distributed on a suitable medium, such as an optical storage medium or a solid-state medium, supplied together with or as part of other hardware, but may also be distributed in other forms, such as via the Internet or other wired or wireless telecommunication systems.

In some embodiments, the present invention also includes a computer program for controlling the electric circuit fragment described above. The computer program comprises program code such as, e.g., executable instructions, for causing the electric circuit fragment to switch from its transmit state into its receive state or *vice versa* by implementing the above-described method, when run on a computing device such as a personal computer (PC), a field programmable gate array (FPGA), microcontroller or a complex programmable logic device (CPLD), a processor, a processing circuit, or other computing device.

In some embodiments, the computer program is stored in one or more memories. In some embodiments, a memory includes a non-transitory computer readable medium. For example, the memory may include any one or a combination of volatile memory elements (e.g., random-access memory RAM, such as DRAM, and SRAM, etc.) and nonvolatile memory elements (e.g., ROM, Flash, solid state, EPROM, EEPROM, hard drive, tape, CDROM, etc.). The memory may be in communication with the one or more computing devices. In some embodiments, the present invention includes a non-transitory computer readable medium storing, e.g., the computer program.

Any reference signs in the claims should not be construed as limiting the scope.

The invention relates to an electric circuit fragment comprising a coil, a low noise amplifier, a first switch, a power amplifier and a second switch. The coil is configured for generating an oscillating magnetic field in a transmit state and/or for detecting an external oscillating magnetic field in a receive state. The low noise amplifier is connected in series to the coil. The first switch is connected in parallel to the low noise amplifier and is configured to short-circuit input-terminals of the low noise amplifier. The power amplifier is connected in series to the low noise amplifier. The second switch is arranged between the power amplifier output and ground potential, and is configured to ground the power amplifier output in the receive state. Thereby, it is possible to improve the shielding of the low noise amplifier, in particular, during the transmit state of the electric circuit fragment.

## Claims

1. An electric circuit fragment (300) for or of an electric circuit, the electric circuit fragment (300) having a transmit state and a receive state and comprising:
- at least one coil (314) configured for generating an oscillating magnetic field in the transmit state and/or for detecting an external oscillating magnetic field in the receive state,
- a low noise amplifier (306) that is connected in series to the at least one coil (314) and configured for amplifying a first voltage signal induced in the at least one coil (314) by the detected external oscillating magnetic field in the receive state,
- a first switch (312) connected in parallel to the low noise amplifier (306), and configured to short-circuit input terminals of the low noise amplifier (306) in the transmit state by switching the first switch (312) into its conductive state or to switch into its isolating state in the receive state,
- a power amplifier (302) connected with a power amplifier output (304) to the low noise amplifier (306) in series, and configured for amplifying a received second voltage signal and for providing an amplified second voltage signal to the at least one coil (314) in the transmit state, and
- a second switch (316) arranged between the power amplifier output (304) and ground potential (310), and configured to ground the power amplifier output (304) in the receive state by switching to its conductive state, and switching in the transmit state to its isolating state.

2. The electric circuit fragment (300) of claim 1, wherein the first switch (312) and/or the second switch (316) is of a transistor-based switch type.

3. The electric circuit fragment (300) of claim 2, wherein the first switch (312) and/or the second switch (316) is a FET.

4. The electric circuit fragment (300) of at least one of the preceding claims, wherein the first switch (312) and/or the second switch (316) is a PIN diode.

5. The electric circuit fragment (300) of any of the preceding claims, in which the power amplifier output (304) is configured as an H-bridge that is configured such as to short-circuit output terminals of the power amplifier output (304) when in receive state.

6. The electric circuit fragment (300) of at least one of the preceding claims, comprising a transformer (410) connected in parallel to the low noise amplifier (306) and in parallel to the first switch (312) for transforming the first voltage signal provided by the at least one coil (314) before it enters the low noise amplifier (306).

7. The electric circuit fragment (300) of claim 6, wherein a third switch is connected in series between the low noise amplifier (306) and the transformer (410).

8. The electric circuit fragment (300) of any of the preceding claims, comprising a fourth switch connected in parallel to the low noise amplifier (306) and in parallel to the transformer (410).

9. The electric circuit fragment (300) of any of the preceding claims, comprising a symmetrical power amplifier as the power amplifier (302), symmetric switches, a symmetrical coil as the at least one coil (314), and a transformer (410) having two symmetrical primary sides to implement a balanced configuration.

10. A detector system for tracking and/or sensing for a micro-magnetic resonator, the detector system comprising:
- an electric circuit that comprises the electric circuit fragment (300) of at least one of the preceding claims, and
- a ferromagnetic object, wherein
the electric circuit fragment (300) is arranged and configured for generating an oscillating magnetic field in its transmit state to excite a mechanical resonance of the ferromagnetic object such that the ferromagnetic object generates an external oscillating magnetic field that can be detected by the electric circuit fragment (300) in its receive state.

11. A method of operating the electric circuit fragment (300) according to at least one of claims 1 to 9, the method comprising the steps of:
- switching the first switch (312) into its conductive state to shorten the low noise amplifier (306) and switching the second switch (316) into its isolating state, for bringing the electric circuit fragment (300) into its transmit state, and
- switching the first switch (312) into its isolating state and switching the second switch (316) into its conductive state to ground the power amplifier output (304) for bringing the electric circuit fragment (300) into its receive state.

12. The method of claim 11, comprising switching the first switch (312) from its conductive state in its isolating state or vice versa after a first predefined time period that begins with a switching of the second switch (316) from its conductive state in its isolating state or vice versa, or comprising switching the second switch (316) from its conductive state in its isolating state or vice versa after a second predefined time period that begins with a switching of the first switch (312) from its conductive state in its isolating state or vice versa.

13. The method of claim 11, comprising switching the first switch (312) into its conductive state while the second switch (316) is still in its conductive state or comprising switching the second switch (316) into its conductive state while the first switch (312) is still in its conductive state.

14. A computer program for controlling the electric circuit fragment (300) of at least one of claims 1 to 9, the computer program comprising program code for causing the electric circuit fragment (300) to switch from its transmit state into its receive state or vice versa by implementing the method according to any of claims 11 to 13, when run on a computing device.

15. A non-transitory computer readable data medium storing the computer program of claim 14.
